Europäisches Patentamt

European Patent Office

Office européen des brevets

(11) Publication number: **0 362 407**
**A1**

## (12) EUROPEAN PATENT APPLICATION
### published in accordance with Art. 158(3) EPC

(21) Application number: **89903792.3**

(22) Date of filing: **28.03.89**

(86) International application number:
**PCT/JP89/00324**

(87) International publication number:
**WO 89/09508 (05.10.89 89/24)**

(51) Int. Cl.5: **H02H 9/02 , G01D 5/26**

(30) Priority: **31.03.88 JP 78460/88**

(43) Date of publication of application:
**11.04.90 Bulletin 90/15**

(84) Designated Contracting States:
**DE FR GB**

(71) Applicant: **FANUC LTD**
**3580, Shibokusa Aza-Komanba Oshino-mura**
**Minamitsuru-gun Yamanashi 401-05(JP)**

(72) Inventor: **IKEDA, Yoshiaki**
**1563-13, Uchikoshi-cho**
**Hachioji-shi Tokyo 192(JP)**
Inventor: **KUWASAWA, Mitsuru**
**Okayama-Haitsu 3 1893-6, Kawashimada**
**Gotenba-shi Shizuoka 412(JP)**

(74) Representative: **Billington, Lawrence Emlyn et al**
**HASELTINE LAKE & CO Hazlitt House 28**
**Southampton Buildings Chancery Lane**
**London WC2A 1AT(GB)**

(54) **POWER SUPPLY APPARATUS.**

(57) A power supply apparatus for supplying backup power (12) to pulse encoder (24, 34) for detecting the rotation speed of a servomotor. In normal operation a negligible voltage drop occurs, while in the event of a short circuit the current is decreased. Instead of the conventional fuse, a heat-sensitive, protective resistor (R) is provided between the pulse encoders (24, 34) as an external unit and the backup power (12) so as to save labor of exchanging the fuse.

Fig. 2

Xerox Copy Centre

DESCRIPTION

POWER SUPPLY APPARATUS

Technical Field

This invention relates to a power supply apparatus for supplying back-up power to a pulse coder which detects the rotational velocity of a servomotor.

Background Art

Machine tools controlled by numerical control apparatus (NC apparatus) widely employ servomotors. In order to accurately control the position of the machine or control the rotational velocity of a spindle, absolute pulse coders (pulse coders) for detecting rotational velocity are mounted on these servomotors. Based on the signal from the pulse coder, the servomotor is controlled from, say, an axis controller in order to control the particular axis of the machine tool.

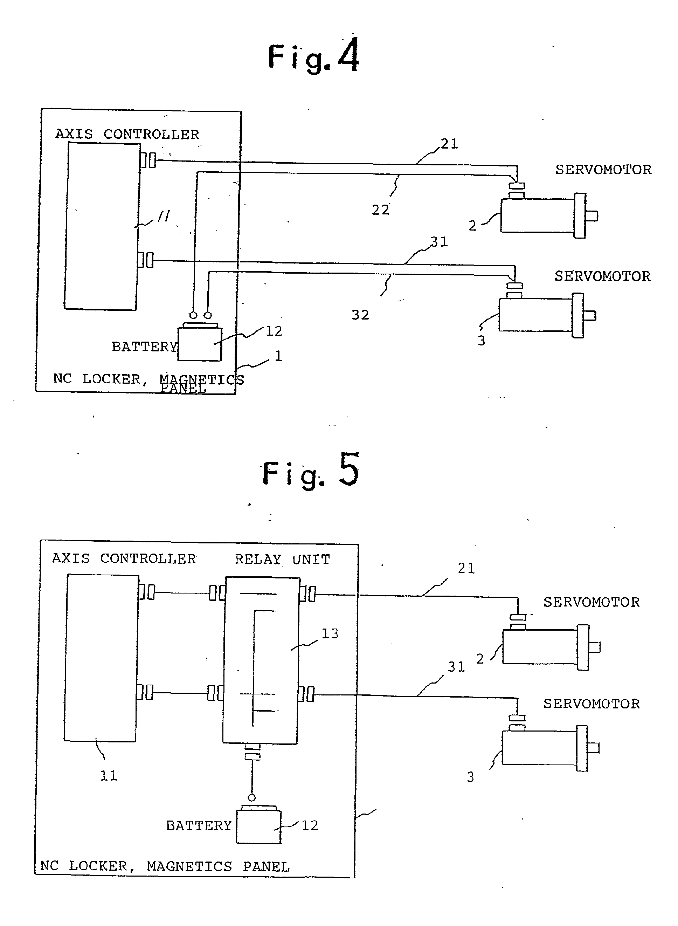

Fig. 4 illustrates a conventional system in which the locker or magnetics penel 1 of an NC apparatus is provided with a battery unit 12 and power is supplied to pulse coders provided on respective servomotors 2, 3 as external units. The servomotors 2, 3 are connected to an axis controller 11 by respective cables 21, 31 for control signals, and the battery unit 12 backs up the pulse coders mounted on the servomotors 2, 3 by separate cables 22, 32.

More specifically, since it is necessary for the present position of a movable element moved by the servomotor to be stored by the pulse coder even when power is not being supplied to the machine tool, the pulse coder is backed up by DC power at all times. For this reason, a battery power supply line is provided along with the signal cable between the NC apparatus and the external unit having the pulse coder. However, in order to effect the connection to each servomotor of the machine tool in this conventional system, special cables are required and these cables are troublesome to handle.

Accordingly, a power supply system using a relay unit 13 has been considered, as shown in Fig. 5. With this system, the axis controller 11 and battery unit 12 are both connected to the relay unit 13, and the magnetics panel 1 can be connected to the servomotors 2, 3 of the machine tool from the relay unit by cables 21, 31, obtained by integrating the power supply lines and control signal lines. Thus, the labor involved in separately installing the power supply lines is eliminated so that it is easier to deal with the connecting cables.

However, if a short-circuit should occur in the circuitry for feeding current from the battery unit to the pulse coder, not only will the present position be lost on the machine-tool side but also normal operation of the machine tool will be impeded in the event of damage to the signal lines. Accordingly, countermeasures for dealing with burning of a cable including a signal line and a power line are necessary, wherein a fuse is inserted in the current feed circuitry between the battery unit and the pulse coder in such a manner that the cables and related components, such as a printed circuit board for axis control and the relay circuitry, will not burn in the event of a short-circuit, the fuse burning open instead when a short-circuit develops.

However, with the system for dealing with accidents by inserting the fuse in the current feed circuitry, the fuse burns through immediately due to an overcurrent caused by a short-circuit, as a result of which the electric line is interrupted. When this occurs, burning of the cables and related components is avoided but the supply of current to the pulse coder is cut off, thereby causing interruption of the position signal, detected thus far by the pulse coder, from the machine tool. In other words, even if the system of the kind shown in Fig. 5 is used, the measures for dealing with cable burning using a fuse result in loss of present position in the servo-circuit system. Another problem arises also in terms of maintenance, namely the labor involved in fuse replacement.

Disclosure of the Invention

The present invention has been devised in order to solve the foregoing problems and its object is to provide a power supply apparatus in which current is suppressed without interrupting a circuit when an abnormality occurs in current feed circuitry, and with which it is possible to reduce the labor involved in maintenance.

In accordance with the present invention, there can be provided a power supply apparatus in which power supplied to a pulse coder mounted on a servomotor is supplied from a power supply via a cable serving as a current feed circuit, characterized in that a protective resistor which prevents overcurrent is serially connected to the current feed circuit.

Thus, the power supply apparatus of the present invention is such that a protective resistor the resistance value whereof rises sharply due to the generation of heat when a fed current increases abnormally is serially connected to a current feed circuit. When current becomes excessive, therefore, the current is suppressed by the increased resistance value of the protective resistor, whereby component burn-out and circuit interruption are avoided.

Brief Description of the Drawings

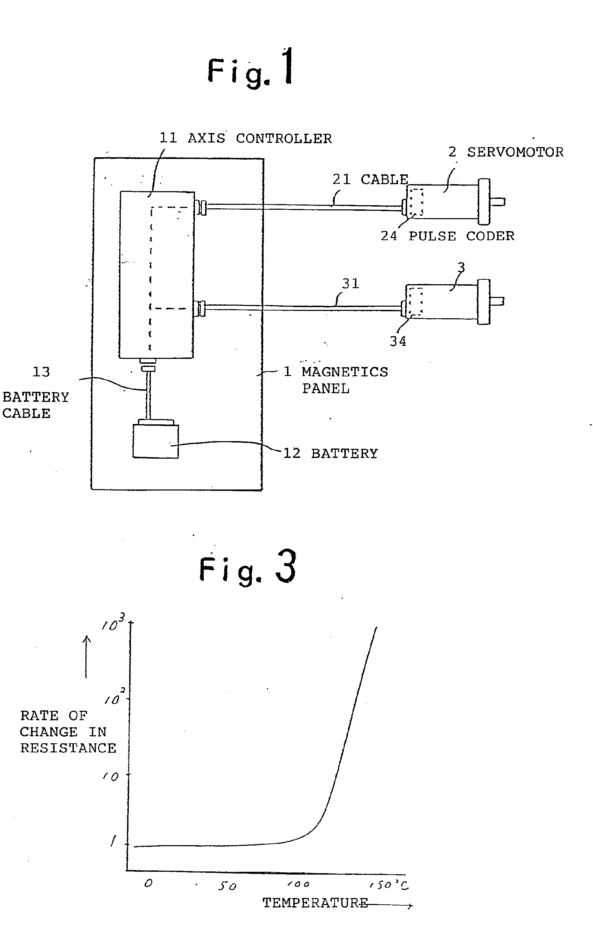

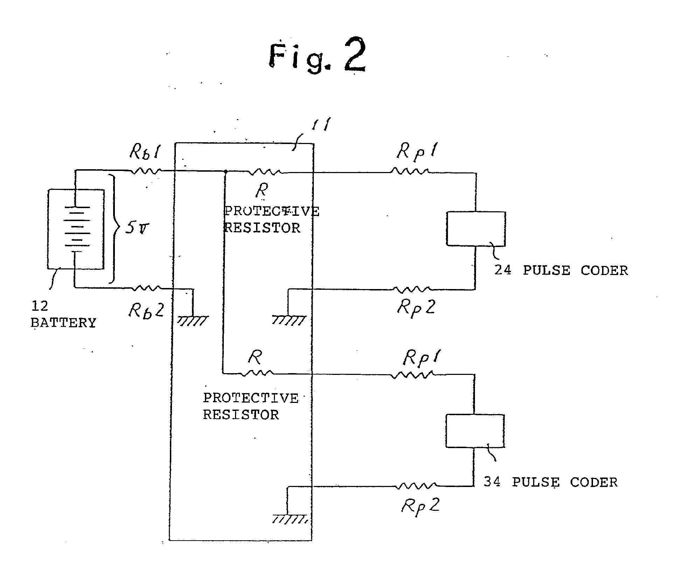

Fig. 1 is a block diagram illustrating an embodiment of the present invention, Fig. 2 is a circuit diagram of the embodiment, Fig. 3 shows a curve indicating an example of a resistance-temperature characteristic of a protective resistor used in the present embodiment, and Figs 4 and 5 are a block diagram illustrating an example of the prior art.

Best Mode for Carrying Out the Invention

An embodiment of the present invention will now be described in detail with reference to the drawings.

In Fig. 1, numeral 1 denotes a magnetics panel of an NC apparatus. The panel has an axis controller 11 and a battery 12 serving as the power supply of pulse coders. The battery 12 and the axis controller 11 are interconnected by a battery cable 13.

Numerals 2 and 3 denote servomotors having respective internal pulse coders 24, 34 for detecting rotation. Positional control of the movable element of a machine tool driven by the servomotors 2, 3 is executed based on signals from these pulse coders.

Numerals 21 and 31 are cables which include, in addition to signal lines for controlling the servomotors 2 and 3, signal lines from the pulse coders and current feed circuitry for supplying DC power to the pulse coders. These cables connect the servomotors 2, 3 to the axis controller 11. A printed circuit board having a plurality of terminals is provided on a portion of the axis controller 11 to which the cables are connected and serves to electrically connect various lines between the axis controller 11 and the cables.

The circuit diagram shown in Fig. 2 illustrates a circuit for supplying power to the pulse coders 24, 34 via protective resistors R and shows various cables in a current feed circuit in which the pulse coders are supplied from the battery 12 via the axis controller 11. Examples of the resistance values and voltage values of the circuit portions are as follows:

Vb (battery voltage) = 5.0 V

Vp (terminal voltage value demanded by pulse coders) = 4.8 V

Ip (pulse coder load current) = 200 μA

$Rb_1$, $Rb_2$ (battery cable resistance value) = 0.16 $\Omega$

$Rp_1$ (pulse coder cable resistance value) = 0.93 $\Omega$

$Rp_2$ (pulse coder cable resistance value) = 0.26 $\Omega$

R (protective resistor) = 1.2 $\Omega$

Assuming that the foregoing hold, we have

$V_{p-min}$ =

Vb − [(Rb1+Rb2) x Ip x 2)] − [(R+Rp1+Rp2) x Ip] = 4.99 V

That is, a terminal voltage greater than the demanded value Vp (4.8 V) can be achieved.

In this example, the protective resistor R is inserted in series between the axis controller 11 and the pulse coder cable Rp1 and, as shown in Fig. 3, the resistance-temperature characteristic thereof is such that the rise in resistance value is small within a range of heating caused by a predetermined steady current. The resistance value rises sharply, however, due to the heating action of an overcurrent, so that the current passing through the feed circuit in which the protective resistor is inserted is suppressed by the greater resistance value.

In the embodiment thus constructed, the resistance value of the protective resistor R is maintained at about 1.2Ω by a steady current during ordinary operation of the pulse coder. If a short-circuit occurs for some reason, the protective resistor R is heated by the short-circuit current and its resistance value rises sharply. Owing to the increased resistance value, the current passing through the circuit is held below a fixed value despite the short-circuit. Accordingly, burning of the cables of the current feed circuit and of the printed circuit board in the axis controller due to overcurrent is prevented. The protective resistor is composed of a temperature dependent-type semiconductor ceramic.

When the cause of the short-circuit is eliminated and the current value returns to the steady state, the temperature of the protective resistor R falls and its resistance value is maintained at the former 1.2Ω or so.

Though an embodiment of the present invention has been described, the invention it not limited thereto but can be modified in various ways without departing from the scope of the claims.

Industrial Applicability

The power supply apparatus of the present invention is such that a protective resistor for preventing overcurrent is inserted in a current feed circuit which supplies power from a battery to a pulse coder. Even if a short-circuit accident should occur, therefore, an overcurrent is suppressed so that burning of related components can be prevented. In addition, a printed circuit board also will not burn. Moreover, since the resistance value of the protective resistor returns to the steady state when the cause of the short-circuit accident is eliminated, labor as involved in fuse replacement can be curtailed.

CLAIMS:

1. A power supply apparatus in which power supplied to a pulse coder mounted on a servomotor is supplied from a power supply via a cable serving as a current feed circuit, characterized in that a protective resistor which prevents overcurrent is serially connected to said current feed circuit.

2. A power supply apparatus according to claim 1, characterized in that said protective resistor uses a thermosensitive resistance element having a resistance value which rises as a result of self-heating due to passage of a current therethrough.

3. A power supply apparatus according to claim 1, characterized in that said protective resistor is a temperature-dependent semiconductor ceramic.

4. A power supply apparatus according to claim 1, characterized in that said servomotor is provided on a machine tool controlled by a numerical control apparatus.

# Fig. 1

11 AXIS CONTROLLER

2 SERVOMOTOR

21 CABLE

24 PULSE CODER

31

3

34

13 BATTERY CABLE

1 MAGNETICS PANEL

12 BATTERY

# Fig. 3

RATE OF CHANGE IN RESISTANCE

$10^3$

$10^2$

$10$

$1$

$0$    $50$    $100$    $150°C$

TEMPERATURE

# Fig. 2

$R_b1$

$R$
PROTECTIVE
RESISTOR

$R_p1$

$5v$

24 PULSE CODER

12
BATTERY

$R_b2$

$R_p2$

$R$
PROTECTIVE
RESISTOR

$R_p1$

34 PULSE CODER

$R_p2$

# Fig.4

AXIS CONTROLLER

SERVOMOTOR

21

22

2

SERVOMOTOR

31

32

3

BATTERY

12

1

NC LOCKER, MAGNETICS PANEL

# Fig.5

AXIS CONTROLLER    RELAY UNIT

21

SERVOMOTOR

13

2

11

31

SERVOMOTOR

3

BATTERY    12

NC LOCKER, MAGNETICS PANEL

# INTERNATIONAL SEARCH REPORT

International Application No  PCT/JP89/00324

**I. CLASSIFICATION OF SUBJECT MATTER** (if several classification symbols apply, indicate all) [6]

According to International Patent Classification (IPC) or to both National Classification and IPC

Int. Cl$^4$  H02H9/02, G01D5/26

**II. FIELDS SEARCHED**

| Minimum Documentation Searched [7] | |
|---|---|
| Classification System | Classification Symbols |
| IPC | H02H9/02, G01D5/26-5/38 |

| Documentation Searched other than Minimum Documentation to the Extent that such Documents are Included in the Fields Searched [8] | |
|---|---|
| Jitsuyo Shinan Koho | 1926 – 1988 |
| Kokai Jitsuyo Shinan Koho | 1971 – 1988 |

**III. DOCUMENTS CONSIDERED TO BE RELEVANT** [9]

| Category [*] | Citation of Document, [11] with indication, where appropriate, of the relevant passages [12] | Relevant to Claim No. [13] |
|---|---|---|
| Y | JP, A, 60-188814 (Hitachi, Ltd.) 26 September 1985 (26. 09. 85) Figs. 1 to 3 (Family: none) | 1-4 |
| Y | JP, A, 56-56601 (Nihon Jidosha Buhin Sogo Kenkyusho Kabushiki Kaisha) 18 September 1981 (18. 09. 81) Figs. 1 to 7 (Family: none) | 1-4 |

\* Special categories of cited documents. [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| June 8, 1989 (08. 06. 89) | June 26, 1989 (26. 06. 89) |
| International Searching Authority | Signature of Authorized Officer |
| Japanese Patent Office | |

Form PCT ISA 210 (second sheet) (January 1985)